(19) **Europäisches Patentamt**

**European Patent Office**

**Office européen des brevets**

(11) **EP 0 748 057 B1**

(12) # EUROPEAN PATENT SPECIFICATION

(45) Date of publication and mention
of the grant of the patent:
**10.05.2000 Bulletin 2000/19**

(21) Application number: **93913548.9**

(22) Date of filing: **21.06.1993**

(51) Int. Cl.[7]: **H03M 13/23**, H04L 1/00

(86) International application number:
**PCT/JP93/00830**

(87) International publication number:
**WO 95/01008 (05.01.1995 Gazette 1995/02)**

(54) **BIT ERROR COUNTING METHOD AND COUNTER**

BITFEHLER ZÄHLVERFAHREN UND ZÄHLER

METHODE DE COMPTAGE DES ERREURS SUR LES BITS ET COMPTEUR

(84) Designated Contracting States:
**DE FR GB IT SE**

(43) Date of publication of application:
**11.12.1996 Bulletin 1996/50**

(73) Proprietor:
**Oki Electric Industry Company, Limited**
**Tokyo 105 (JP)**

(72) Inventor:
**ABE, Masami**
**Oki Electric Industry Co., Ltd.**
**Minato-ku Tokyo 105 (JP)**

(74) Representative:
**Read, Matthew Charles et al**
**Venner Shipley & Co.**
**20 Little Britain**
**London EC1A 7DH (GB)**

(56) References cited:
| | |
|---|---|
| EP-A- 0 139 511 | EP-A- 0 234 558 |
| EP-A- 0 425 153 | EP-A- 0 426 894 |
| EP-A- 0 458 229 | EP-A- 0 463 598 |
| EP-A- 0 543 586 | JP-A- 1 235 073 |
| JP-A- 62 159 519 | JP-B- 63 006 173 |
| JP-U- 61 000 338 | US-A- 4 823 346 |

- HIROSHI MIYAGAWA, YOSHIHIRO IWATARE, HIDEKI IMAI, "Code Theory", 25 October 1974, SHOKODO K.K. (Tokyo), p. 370, 373, 375.
- G. C. CLARK JR, R. C. DAVIS: "Reliability-of-decoding indicators for maximum likelihood decoders ", PROCEEDINGS OF THE ANNUAL HAWAII INTERNATIONAL CONFERENCE ON SYSTEM SCIENCE, , 11-01-1972, vol. 5, no. , pages 447 to 450

**Description**

The present invention relates to a method of and a device for counting errors of a signal in the digital communication system, and particularly, to a method of and a device for counting errors of a signal per bit in the system where an error correction is performed using the Viterbi decoding process.

G. Clark and D. Davis in "Reliability-of-decoding indicators for maximum likelihood decoders", Proceedings of the annual Hawaii international conference on system science, vol 5, p 447-450 (1972) discuss several methods of error counting. JP 1235073 discloses a system where such techniques may be applied to distinguish between different types of data.

The background art highly associated with the present application is shown, for example, in DSP Q0256 Technical Data Sheet p. 13, p. 15-16, Qualcom Company. In this literature, an example of a technique is disclosed, which realizes the process, by the hardware, for counting signal errors attendant upon transmission when a signal encoded by the convolutional encoding is transmitted from a transmitter side and the process for restoring the original signal is performed using the Viterbi decoding at a receiver side.

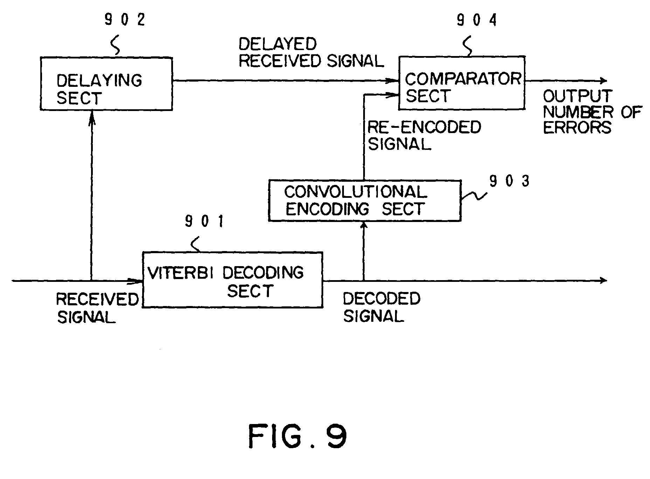

Figure 9 shows an outline of a circuit structure for performing the process. In the disclosed technique, a Viterbi decoding section 901 at a receiver side tries to perform the same process as at a transmitter side so as to compare the result with a signal actually sent from the transmitter side to detect an error.

In Figure 9, a received signal is sent via a transmission line or the like. This received signal has been already applied with the encoding process. There are many kinds of the encoding processes generally known. Here, explanation will be made assuming that the convolutional encoding is applied.

The foregoing received signal is bifurcated so as to be inputted to the Viterbi decoding section 901 and a delaying section 902. The Viterbi decoding section 901 performs the generally known Viterbi decoding relative to the received signal. The Viterbi decoding is a process for restoring a signal before the encoding from the received signal applied with the convolutional encoding. The Viterbi decoding will be described later in detail.

The signal restored to a state before the encoding at the Viterbi decoding section 901 (hereinafter referred to as the decoded signal) is outputted as it is and also sent to a convolutional encoding section 903. Here, the same process as the foregoing process for generating the received signal is performed. Accordingly, an output of the convolutional encoding section 903 (hereinafter referred to as the re-encoded signal) is considered to be the same as the received signal.

On the other hand, the delaying section 902 outputs the received signal with a delay of a constant time. By this delay, output timings of the re-encoded signal and the received signal are matched. Accordingly, the delay time at the delaying section 902 should be substantially equal to the sum of the process time of the Viterbi decoding section 901 and the later-described convolutional encoding section 903. The delaying section 902 does not change the signal other than delaying the time as described above.

The re-encoded signal and the delayed received signal are inputted to a comparator section 904. As described above, the input timings of both signals are matched by the effect of the delaying section 902. The comparator section 904 compares these input signals. Although both signals should coincide with each other, if a transmission error is generated in the received signal, both signals do not coincide at a point of occurrence of the error. Depending on this non-coincident portion, the comparator section outputs an error counting output.

A circuit provided with a memory, instead of the delaying section 902, for storing the received signal is also known. In this circuit structure, the received signal stored in the memory is read out so as to match a timing of an output of the re-encoded signal. Thereafter, the comparator section compares the received signal and the re-encoded signal similarly so as to find out an error.

The technical problems included in the technique disclosed in the foregoing literature are as follows:

First, a scale of the hardware increases. At the receiver side, a re-encoding circuit for performing the re-encoding process and a comparator circuit for comparing the re-encoded signal and the received signal should be provided. Further, due to the time required for the decoding and the re-encoding, the delaying section 902 or the memory described above becomes necessary. Thus, the circuit scale can not be avoided from increasing.

Second, the number of executing steps is large. In the foregoing technique, the encoding process similar to that at the transmitter side and the decoding process should be executed at the receiver side. Thus, the re-encoding process, the comparison process and the like are necessary at the receiver side.

Third, if the error correction is incomplete, this influences the counting. In the foregoing technique, it is premised that the signal applied with the Viterbi decoding at the receiver side is a correct signal. However, there is no means provided for judging whether or not the Viterbi decoded signal itself includes an error.

Accordingly, if the error is not corrected completely at a stage of the Viterbi decoding so that the error remains in the decoded signal, the correct result can not be obtained also at the subsequent re-encoding stage so that the error counting can not be performed accurately also at the comparison stage.

According to the present invention, there is provided a method of detecting errors in a convolutionally encoded signal using Viterbi decoding, the method comprising establishing, using a decoding procedure, a survivor path corresponding to a decoded signal, deriving a path metric for the survivor path, determining the number of errors in the decoded signal in dependence on the value of the path metric, wherein the determining of the number of errors in the decoded signal comprises determining whether the value of path metric exceeds a predetermined value and setting the number of errors equal to the value of path metric if the value of path metric is the same or falls below the predetermined value or setting the number of errors equal to a given value if the value of path metric exceeds the predetermined value, and the method further comprises outputting the number of errors together with the decoded signal and an error correction flag to indicate whether the path metric represents the number of errors.

The deriving of the value of path metric may comprise determining the Hamming distance.

The setting of the number of errors to a given value may comprise ascribing a mean error number.

The establishing of a survivor path may comprise selecting the path with the minimum value of path metric when the path has not converged.

A method of distinguishing between a first and second type of encoding procedure used to encode a signal may comprise detecting errors in the encoded signal using a first decoding procedure and determining a first number of errors and detecting errors using a second decoding procedure and determining a second number of errors, comparing the first and second number of errors and in dependence on the comparison selecting either the first or second decoding procedure.

The selecting of either the first or second decoding procedure may comprise adopting the first decoding procedure if the first number of errors is less than a first fixed value.

The selecting of either the first or second decoding procedure may comprise adopting the first decoding procedure if the first number of errors is less than the second number of errors.

The selecting of either the first or second decoding procedure may comprise adopting the second decoding procedure if the second number of errors is less than a second fixed value.

According to the present invention there is also provided a device for detecting errors in a convolutionally encoded signal comprising decoding means to establish a survivor path to derive a path metric for the survivor path and to decode the convolutionally encoded signal, path memory means for storing path information and metric memory means for storing values of path metric the device wherein the means for determining the number of errors in the decoded signal in dependence on the value of the path metric, wherein the means for determining the number of errors ascertains whether the value of path metric exceeds a predetermined value and sets the number of errors equal to the value of path metric if the value of path metric is the same or falls below the predetermined value or sets the number of errors equal to a given value if the value of path metric exceeds the predetermined value and an error operation means to output the number of errors together with the decoded signal and an error correction flag to indicate whether the path metric represents the number of errors.

The value of path metric may be derived from the Hamming distance. The given value may be a mean error number.

The decoding means may comprise means to select the path with the minimum value of path metric when the path has not converged.

Apparatus to identify and decode an encoded signal, may comprise a first said device for detecting errors in the encoded signal wherein a first said decoding means is configured to decode according to a first decoding procedure and a first said error operation means outputs a first said number of errors together with a first said decoded signal, a second said device for detecting errors in the encoded signal wherein a second said decoding means is configured to decode according to a second decoding procedure and a said second error operation means outputs a second said number of errors together with a second said decoded signal, means for comparing the first and second number of errors and means for selecting either the first or second decoded signal in dependence on the comparison.

The means for selecting either the first or second decoded signal may be configured to select the first decoded signal if the first number of errors is less than a first fixed value.

The means for selecting either the first or second decoded signal may be configured to select the first decoded signal if the first number of errors is less than the second number of errors.

The means for selecting either the first or second decoded signal may be configured to select the second decoded signal if the second number of errors is less than a second fixed value.

This has the advantage that the decoder is significantly simplified compared to the prior art decoder, since the re-encoding section, the comparator section and the delaying section are omitted. Furthermore there is a reduction in number of processing steps. Still further, there is an improvement in accuracy of error counting.

Lastly, it can be further enumerated that whether the received signal is the sound signal or the FACCH signal can be identified based on the received signal itself, simultaneously with performing the decoding process.

An embodiment of the present invention will now be described, by way of example, with reference to the accompanying drawings in which:

Figure 1 is a flowchart showing an outline of a procedure of an embodiment of the present invention,

Figure 2 is a block diagram showing a structure of a decoding section,

Figure 3 is a block diagram showing a structure of an encoder with a constraint length of 3,

Figure 4 is an explanatory diagram showing a trellis figure,

Figure 5 is an explanatory diagram showing a trellis figure partially enlarged,

Figure 6 is an explanatory diagram showing calculation of a path metric,

Figure 7 is a flowchart showing a procedure of the Viterbi decoding,

Figure 8 is a flowchart showing an operation procedure of a path metric,

Figure 9 is a block diagram showing a structure of a conventional error counting device,

Figure 10 is a flowchart showing a procedure of signal identification and

Figure 11 is a block diagram showing a structure of a signal identification device.

First, the principle of the Viterbi decoding will be explained. The Viterbi decoding is one of decoding techniques. The decoding is a technique of signal conversion used in combination with the encoding. In the present specification, the encoding represents a method of convening a digital code or the like to be transmitted based on a specific rule in a terminal at a transmitter side in the system of transmitting the digital code or the like. On the other hand, the decoding represents a method which, based on the encoded signal transmitted from the terminal at the transmitter side, derives the digital code before the encoding.

The Viterbi decoding is used in combination with the convolutional encoding. The purpose of performing the encoding and the decoding before and after the transmission is to achieve an encoding gain. The encoding gain is defined by a difference between a theoretical CN ratio where the encoding for achieving a constant error rate is not performed and a CN ratio after the error correcting decoding. The CN ratio represents a ratio between a carrier power of an actuating signal and a noise power. By obtaining such an encoding gain, an influence of a transmission error attendant upon the transmission of the signal can be repressed. Particularly, by using the convolutional encoding and the Viterbi decoding, the error correction can also be performed simultaneously.

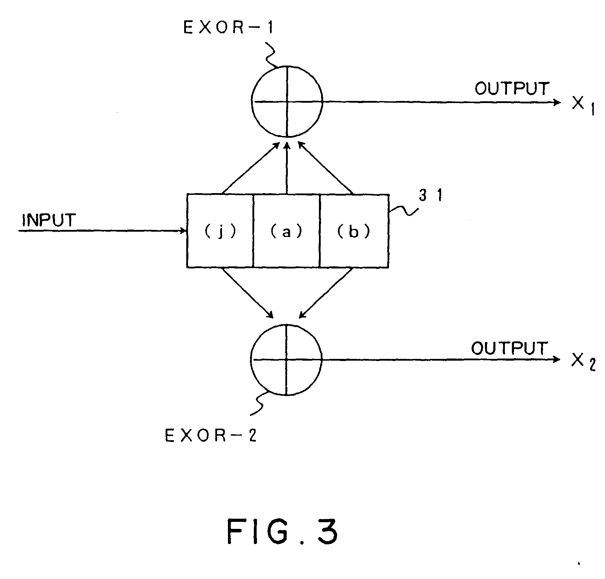

As a background of the Viterbi decoding, the process of the convolutional encoding will be first explained briefly. The convolutional code is produced by mod 2 summing of an input bit and a constant number of preceding bits. Accordingly, as shown in Fig. 3, an encoder is constituted by a shift register and an exclusive OR circuit.

Fig. 3 shows a structure of the encoder having an encoding rate of 1/2 and a constraint length of 3.

The encoding rate represents a ratio between the number of input bits and the number of output bits, and the constraint length represents the number of information bits which affect an output of the encoder. In Fig. 3, 31 denotes a 3-stage shift register having (j), (a) and (b). It is possible to input to the shift register 31 per one bit.

Input data of one bit shifts data in a register (a) to a register (b) and data in a register (j) to the register (a), and then is stored in the register (j).

EXOR-1 and EXOR-2 denote exclusive OR circuits. In the exclusive OR circuits EXOR-1 and EXOR-2, mod 2 summing is performed, respectively. Outputs X1 and X2 of the exclusive OR circuits EXOR-1 and EXOR-2 become an output of the encoder as they are. This output is called an encoded output. The encoded output is taken out every time data of one bit is inputted to the shift register 31. Accordingly, per one bit of the input data, an output of two bits in total is obtained, that is, one bit from each of X1 and X2.

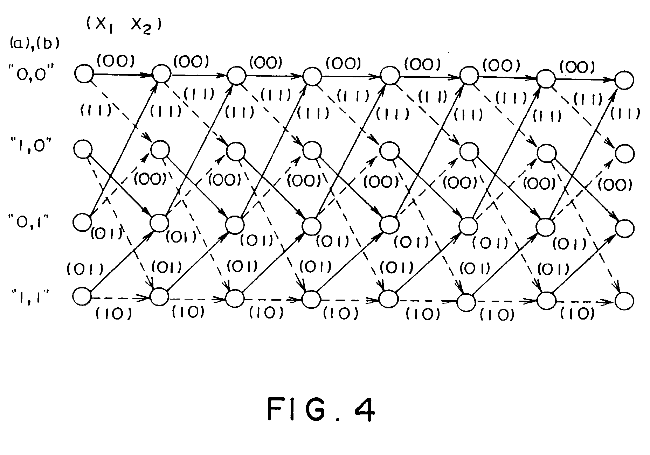

As a technique for conceptually expressing the process of such an encoder, there is one called a trellis figure. Fig. 4 shows this trellis figure prepared based on the structure of the foregoing encoder of Fig. 3.

In Fig. 4, lined-up circles represent possible states of the shift register 31 to be taken except for one bit of the newest input of the encoder, that is, possible states of the registers (a) and (b) to be taken. In general, in case one bit of the newest input is not included, since the shift register of the encoder has (k-1) stages, $2\uparrow$(k-1) states can be taken. In Fig. 3, there are four states of "0, 0", "0, 1", "1, 0" and "1, 1".

In general, the circle representing the state of the shift register is called a node. In Fig. 4, the nodes are arranged in four rows. These four rows represent the four-state of shift register. The initial state of the register is represented by one of four nodes at a left-end column in the initial condition. From this condition, the state shifts to one of nodes belonging to a right-side adjacent column in turn every time one bit is inputted to the encoder. When one bit is further inputted to the encoder in the state at the right end, although not shown in the figure, a transition occurs similarly further rightward in the figure.

However, a transition to a state does not occur all arbitrarily. In Fig. 4, the transitions only occur along arrows connected by arrows. In Fig. 4, each arrow shown by a solid line represents a transition when "0" is inputted to the encoder, while each arrow shown by a dotted line represents a transition when "1" is inputted to the encoder. The arrow connecting between the nodes is called a branch. Each branch is assigned a peculiar value of two figures irrespective of whether it is shown by the solid line or the dotted line.

This two-figure value represents an output value (X1, X2) derived by executing the exclusive OR operations EXOR-1 and EXOR-2 relative to data stored in the shift register 31 of the encoder. For example, when (a) and (b) of the shift register 31 are in a state of "0, 1", if input data is "1", an output X1, which is the exclusive logical sum of three bits 1, 0, 1, becomes 0. On the other hand, an output X2, which is the logical sum of two bits 1, 1, becomes 0. Thus, in Fig. 4, each branch connecting the state "0, 0" to the next state "1, 0" is assigned (00).

In this manner, the process of the encoding is expressed by tracing the branches representing the transitions on the trellis figure. Specifically, by continuity of the branches, a course of the transitions can be shown continuously. This continuous course of the transitions is called a path.

The thus encoded output is transmitted from the terminal at the transmitter side to a terminal at a receiver side via a communication line or the like. At the side receiving the thus transmitted encoded output, the process called decoding is performed for deriving the same signal as the input signal which was inputted to the encoder per one bit. The typical decoding process is a process called the foregoing Viterbi decoding. Hereinbelow, the concept and the procedure of the Viterbi decoding will be explained in detail.

Among the decoding processes, the Viterbi decoding is a procedure particularly called the most likelihood decoding. In this procedure, based on the encoded signal, several candidates of the input signal are supposed and the candidate which is considered to be the correct input signal with the highest probability is adopted as the original input signal from the candidates. This procedure is characterized in that the decoding is performed based on only the encoded signal, that is, not using other signals.

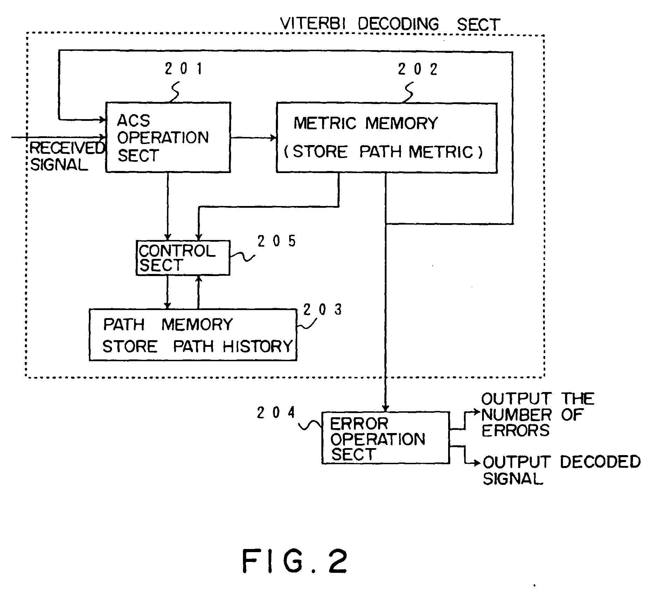

Fig. 2 shows an outline of a decoder to be used for carrying out the present invention. In Fig. 2, the decoder is constituted by an ACS operation section 201, a metric memory 202, a path memory 203, an error operation section 204, and a control section 205 for controlling them. Among them, those excluding the error operation section constitutes a Viterbi decoding section. The Viterbi decoding section executes all the Viterbi decoding process.

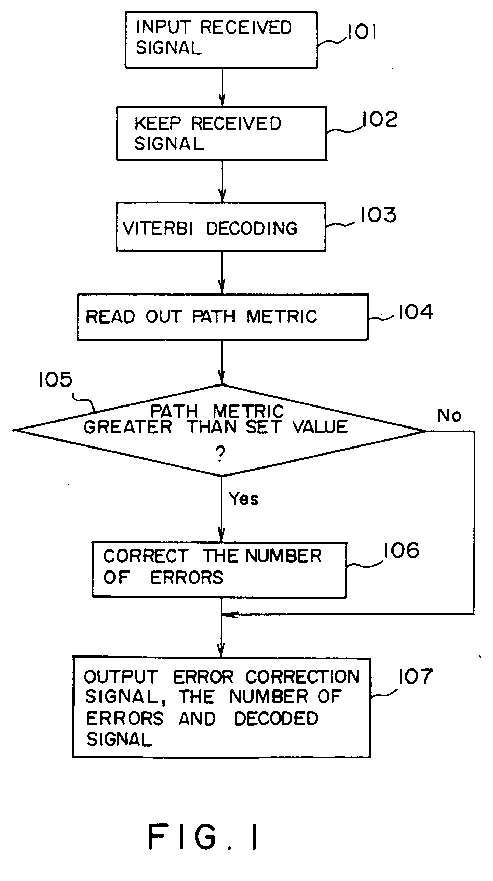

Further, Fig. 1 shows a procedure of carrying out the present invention. First, at step 101, the decoder receives an encoded signal. This encoded signal is stored in a memory provided in the ACS operation section 201. Subsequently, the stored encoded signal is taken out and applied with the Viterbi decoding. During the Viterbi decoding process, a path metric is calculated. This path metric is stored in a memory, not shown, in the ACS operation section 201. Thereafter, the path metric is taken out, and it is checked whether or not the path metric exceeds a predetermined value. Unless the path metric exceeds the predetermined value, the path metric is rendered the number of errors as it is. On the other hand, if the path metric exceeds the predetermined value, another predetermined value is rendered the number of errors. Then finally, the number of errors, an error correction signal representing whether or not the path metric is rendered the number of errors as it is, and a decoded signal derived as the result of the Viterbi decoding are outputted from the decoder.

Subsequently, the foregoing series of processes will be described in detail hereinbelow.

First, the ACS operation section 201 receives an encoded signal formed by two kinds of outputs a1' and a2' of the encoder shown in Fig. 3. Based on the received encoded signal, the ACS operation section 201 estimates the foregoing path and performs the process for restoring the signal inputted to the encoder based on this path. A procedure of this process will be described hereinbelow. Hereinafter, the received encoded signal will be simply called the received signal.

The state of the shift register of the encoder corresponding to this received signal corresponds to one of the four states in the foregoing trellis figure shown in Fig. 4. Until reaching this state, the state transitions should have been performed tracing some of the branches shown in Fig. 4 from one of the initial states at the left end in the trellis figure.

On the other hand, branch metrics correspond to the branches, respectively. The metric can be derived by using a Hamming distance between codewords. Specifically, by comparing the received signal and a metric of each branch in terms of the Hamming distance, a metric per branch can be derived.

Accordingly, in the ACS operation section 201, a path metric is derived per node by summing metrics of all the branches belonging to a path which reaches the corresponding node.

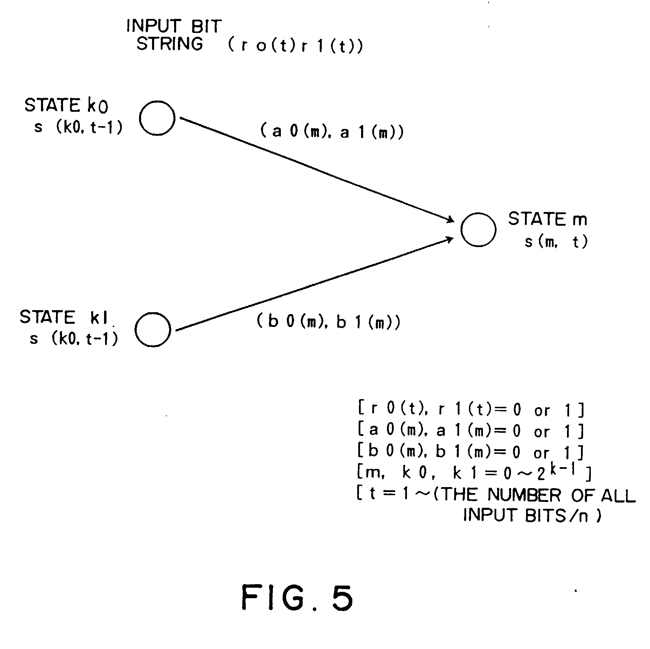

Calculation of the path metric will be described next in detail. Fig. 5 shows a part of the trellis figure of Fig. 4 on an enlarged scale. In Fig. 5, two branches for transition to a specific state m are shown. To these two branches, bit strings $(a0(m), a1(m))$ and $(b0(m), b1(m))$ are assigned, respectively. Each of the assigned bit strings represents an encoded output outputted from the encoder when the state of the encoder shifts via the corresponding branch shown in Fig. 5. Specifically, if the state of the encoder had shifted from a state k0 to the state m, an encoded output $(a0(m), a1(m))$ should have been outputted in response to such a transition. Similarly, if the state of the encoder had shifted from a state k1 to the state m, an encoded output $(b0(m), b1(m))$ should have been outputted in response to such a transition.

On the other hand, a bit string actually received by the Viterbi decoding section 901 is set to be $(r0(t), r1(t))$. It is possible that this bit string differs from the actual encoded output due to inclusion of a transmission error. The transmission error represents a signal error generated in a period from the output of the encoder to the input to the Viterbi decoding section 901.

First, for a state transition corresponding to an arbitrary branch, a Hamming distance is derived relative to the actually received signal.

Calculation of the Hamming distance is executed for each branch according to the following equation:

In case of the transition from the state k0 to the state m,

$$X = EXOR \{a0(m), r0(t)\} + EXOR \{a1(m), r1(t)\}$$

In case of the transition from the state k1 to the state m,

$$Y = EXOR \{b0(m), r0(t)\} + EXOR \{b1(m), r1(t)\}$$

Here, EXOR $\{a0(m), r0(t)\}$ represents that the exclusive logical sum of $a0(m)$ and $r0(t)$ is derived. This is similar in the other terms in the foregoing equations. In this manner, by deriving the exclusive logical sum of the received signal and the branches per n bits of the received signal, the Hamming distances between the received signal and the branches can be derived. Subsequently, the Hamming distances are accumulated for the entire path composed of a series of the state transitions. This sum of the Hamming distances represents a path metric of the entire path. This operation is expressed by the following equation:

$$PM_{TOTAL} = \Sigma [X \text{ or } Y]$$

On the other hand, as the number of the input data increases per n bits (n represents an inverse number of a constraint length), the number of possible paths to be taken becomes $2{\uparrow}n$ times. For this reason, when the input data becomes voluminous, the number of paths becomes enormous so that it is difficult to catch the Hamming distances with respect to the received signal and all possible paths to be taken. Accordingly, every time n bits are received, of two paths reaching each node, one path which renders a path metric to the corresponding node smaller is selected as a survivor path. According to this method, it is sufficient to catch the paths of $2{\uparrow}(n1-1)$ which is equal to the number of nodes. In this case, the path metric is given by:

$$sw0 = min\{s(k0, t-1) + x, s(k1, t-1) + y\}$$

wherein $s(k0, t-1)$ represents a path metric of the state k0 at time (t-1), and $s(k1, t-1)$ represents a path metric of the state k1 at time (t-1).

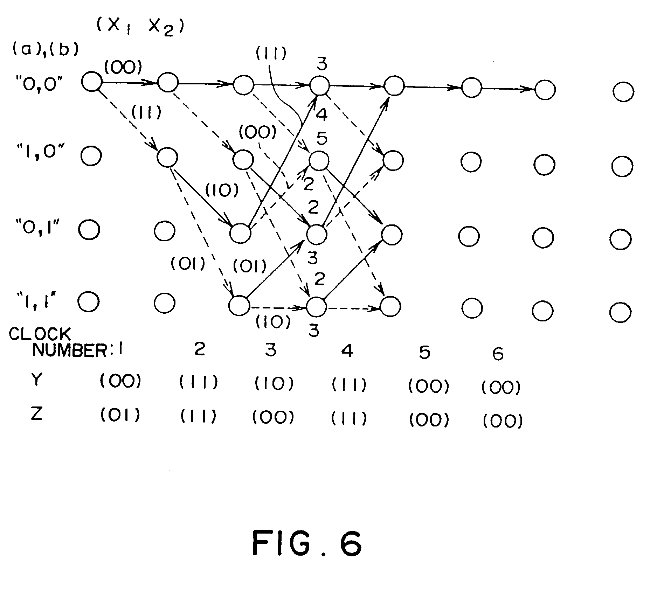

Fig. 6 shows one example of the calculation. The actually received signal is set to be Z=(00, 11, 00, 11). On the other hand, Y=(00, 11, 10, 11) corresponds to the shown paths. At this time, the technique for selecting a survivor path is adopted. This method will be described hereinbelow.

First, in the initial condition at clock numbers 1 and 2 in Fig. 6, only four paths exist. In general, when an initial value of the encoding register is determined, it is in the initial condition of the trellis figure at clock number 2 until n(k-1) bits are received. In Fig. 6, path metrics of the paths which reach the respective states are as follows:

i) When the path is "00"→"00"→"00", the path metric is 3.
ii) When the path is "00"→"10"→"01", the path metric is 2.
iii) When the path is "00"→"00"→"10", the path metric is 1.
iv) When the path is "00"→"10"→"11", the path metric is 2.

Next, in the stationary condition, at each node, the metrics of the two paths inputted to the corresponding node are compared so that the path having the smaller metric is left and the other path is excluded. Here, if the two paths have the same metric value, either one is selected arbitrarily.

A concrete example of the calculation of the path metric will be described using Fig. 6.

First, it is assumed that X=(0, 1, 0, 0) is inputted to the encoder shown in Fig. 3. At this time, an encoded output of the encoder becomes Y=(00, 11, 10, 11). It is assumed that, when this signal was transmitted to the decoding section, errors were caused at the second bit and the fifth bit so that an actually received signal became Z=(01, 11, 00, 11). In this case, the following procedure is used for calculating the path metric:

At clock number 3, there are two paths "0, 0"→"0, 0" and "0, 1"→"0, 0" which reach the state "0, 0". Path metrics of these paths become as follows:

i) 3 + EXOR(00, 00) = 3
ii) 2 + EXOR(11, 00) = 4

As a result, i) gives a smaller path metric. Based on this result, i) is adopted as a survivor path.

When processed similarly for all the states, the following four paths are selected:

"0, 0"→"0, 0"→"0, 0"→"0, 0"
"0, 0"→"1, 0"→"1, 1"→"0, 1"
"0, 0"→"1, 0"→"0, 1"→"1, 0"
"0, 0"→"0, 0"→"1, 0"→"1, 1"

Similarly, at clock number 4, paths which reach the respective states become:

"0, 0"→"0, 0"→"1, 0"→"0, 1"→"0, 0"
"0, 0"→"1, 0"→"0, 1"→"1, 0"→"0, 1"
"0, 0"→"0, 0"→"0, 0"→"0, 0"→"1, 0"
"0, 0"→"1, 0"→"0, 1"→"1, 0"→"1, 1"

As noted above, in the stationary condition, the four paths always become the survivor paths. However, finally, one path should be selected of these four paths. For this, there is a method in which the metrics of the four paths are compared so as to select the path giving the minimum path metric. However, in practice, tail bits of (k-1) bits are added after the input signal and encoded so that one path can be selected in accordance therewith.

Hereinbelow, a procedure of deriving this path metric will be described in detail.

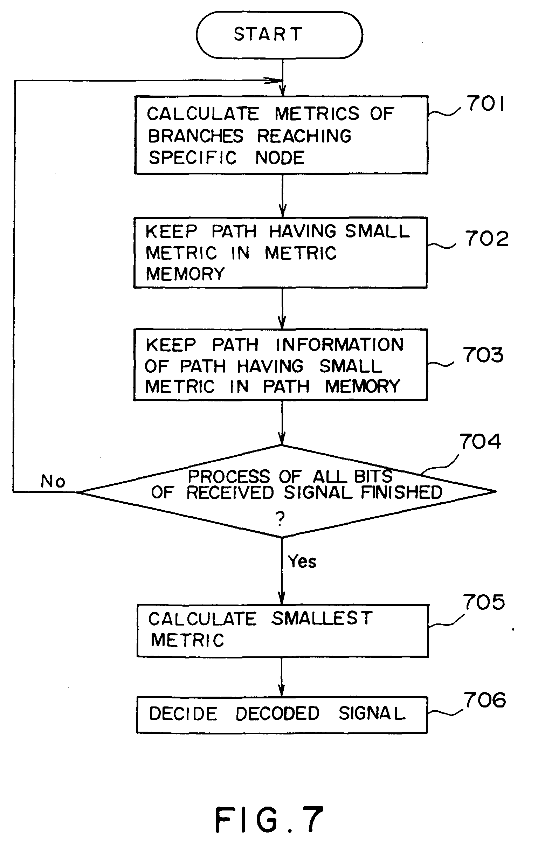

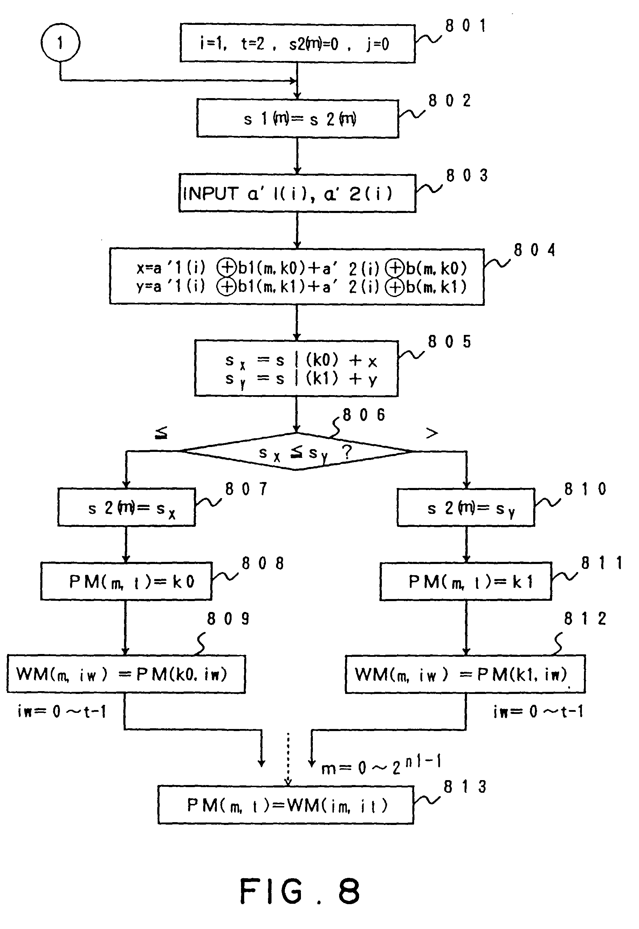

Fig. 7 shows processes executed at the ACS operation section 201 and the control section 205. First, at steps 701 and 702, calculation of path metrics and selection of a survivor path are performed. This procedure is shown in Fig. 8.

First, at step 801, initial values are set. Here, i is a value representing a bit number of the input which corresponds to the encoded received signal, t is a value representing state transition times for a branch which is an operation object, s2(m) is a value representing a path metric of a path which reaches the state m, and j is a value representing the number of bits of a decoded signal. Subsequently, at step 802, s1(m) = s2(m).

Subsequently, at step 803, a pair of received signals a'1(i) and a'2(i) are inputted. These are signals obtained by adding errors to signals outputted from the encoder in response to the i-th bit of the signal inputted to the encoder and have one bit, respectively.

Subsequently, at step 804, an operation of the branch metrics is executed. Values of b1(m, k0), b2(m, k0), b1(m, k1) and b2(m, k1) shown in Fig. 8 can be derived by calculation called a generating function which is known to a person skilled in the art. Each of these values takes 1 or 0. By deriving the exclusive logical sums of these values and a pair of the received signals a'1(i) and a'2(i) inputted at step 802, respectively, a pair of branch metrics x and y corresponding to the i-th state transition are derived. Like in Fig. 5, k0 and k1 are values representing the nodes, respectively.

Next, at step 805, the derived branch metrics are added to path metrics corresponding to survivor paths to corresponding nodes, respectively. Here, two kinds of path metrics to a branch corresponding to the inputted received signals a'1(i) and a'2(i) are derived. Here, the derived path metrics are always of two kinds. This is because there exist two branches inputted to an arbitrary node and there exists one survivor path relative to an arbitrary branch.

The survivor path referred to here is a specific path selected from all the paths including branches corresponding to the (i-1)th and preceding state transitions according to a procedure which will be described next.

Subsequently, at step 806, the two kinds of the path metrics are compared. As a result of this comparison, the path having the smaller path metric is adopted as a survivor path. At step 807 or 810, the path metric adopted at step 806 is substituted for a variable s2(m) representing a path metric of a survivor path. Subsequently, at step 809 or 812, a value k0 representing the node which the survivor path transits, is substituted for a variable PM(m, t) stored in the path memory. The processes at steps 802 to 812 are repeatedly executed while $m = 0 \sim 2\uparrow(n1-1)$. Thereafter, the value PM(m, t) stored in the path memory is substituted for a variable WM(m, iw) stored in a working memory.

Thereafter, as shown at step 704 in Fig. 7, it is determined whether or not the process of all the bits of the received signal is finished. The processes at step 704 and subsequent steps are executed at the control section 205. If the path is not converged at this stage, as a method for obtaining a decoded signal as correct as possible, the smallest metric is read out from the metric memory at step 705, and the decoded signal is decided at step 706 based on a path corresponding to the smallest metric.

After completion of this calculation, a value of the variable WM(im, it) already stored in the working memory is substituted for a variable M(m, it). The process is executed in ranges of $it = 0 \sim t-1$ and $m = 0 \sim 2\uparrow(n1-1)-1$, respectively.

However, it is possible that the error contained in the received signal is not corrected completely in the process of the Viterbi decoding. For finding out such a case, at step 105 in Fig. 1, it is judged whether or not the already derived path metric becomes greater than the set value. If the path metric is greater than the set value, the decoded signal includes many errors. In this case, it is doubtful whether or not the optimum path was selected as a survivor path in the course of the foregoing decoding.

In this manner, after finishing decoding the received signal, a value of the path metric stored in the metric memory is read out. At this time, the value of the metric memory corresponds to the foregoing optimum path. By tracing this optimum path, the decoded signal can be obtained. Accordingly, it can be said that the value of the path metric stored in the metric memory corresponds to the decoded signal. Further, since the value of the path metric is the sum of the branch metrics and the branch metric is derived by the Hamming distance between the branch and the received signal, assuming that the optimum path precisely reproduces the input signal before the encoding, it is understood that the value of the path metric is equal to the number of error bits of the received signal.

Thus, the value of the path metric is outputted as it is representing the number of errors.

On the other hand, when the number of errors exceeds the maximum number of errors which can be corrected by the Viterbi decoding, a correction process is performed, wherein a mean value of the number Nov of errors relative to the number j of the newest errors exceeding a set threshold value, that is,

$$Ner = (\Sigma\ Nov)\ /\ j$$

is used as the number of errors. At this time, Ner is outputted from the control section instead of the value of the path metric, and the value of the path metric is rendered invalid as an output of the number of errors. This correction process continues to be explained.

Further, by using the number of errors derived in the foregoing method, identification of the signal can be performed. Hereinbelow, this process will be explained.

In general, encoding methods for a sound signal and a FACCH signal differ to some degree. Accordingly, their decoding methods should also differ inevitably. When a decoding method which does not correspond to an encoding method of each signal is used upon decoding the signal, the number of errors increases apparently. This is because, even if the received signal contains no error, since the decoding method is not proper, the accurate decoded signal can not be obtained. Accordingly, errors are generated apparently corresponding to errors in the decoded signal.

Therefore, while monitoring the number of errors, the decoding is repeatedly executed using different methods relative to the same received signal. Subsequently, the numbers of errors attendant upon the decoding in plural times are compared. As a result of this comparison, it can be judged that the decoding method with less errors is a proper decoding method for the received signal. If this is performed for both the sound signal and the FACCH signal, it can be judged whether the received signal is the sound signal or the FACCH signal.

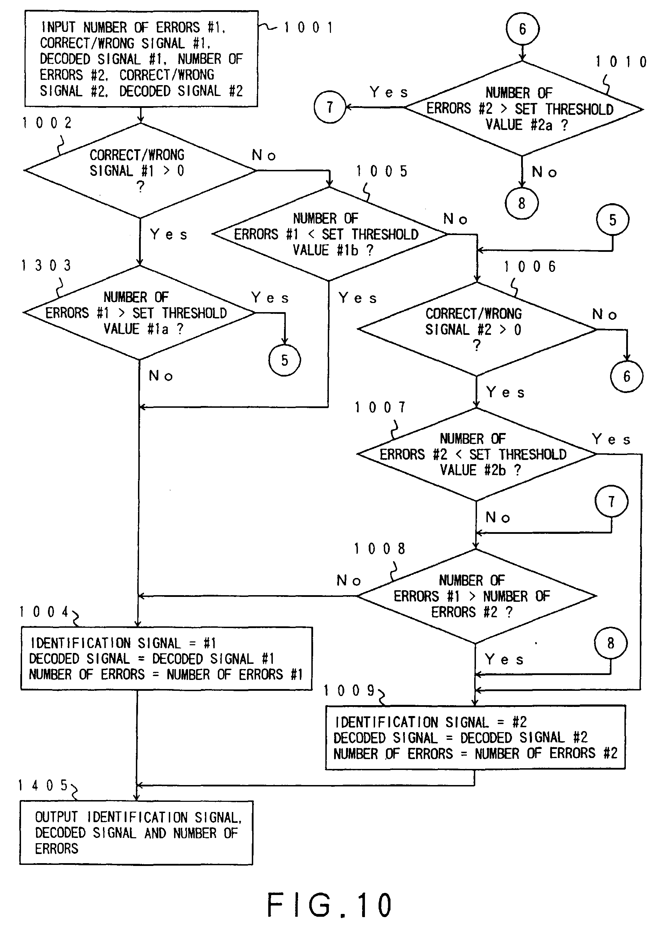

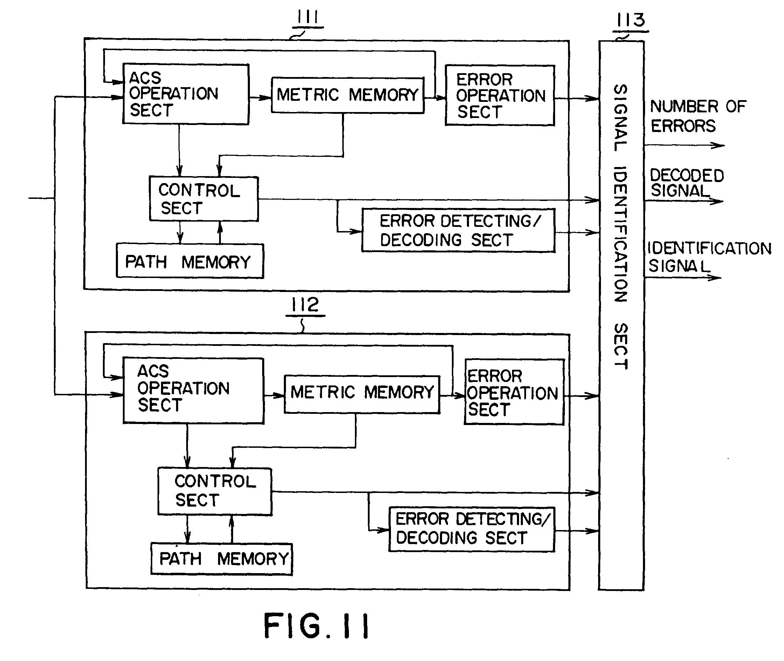

Fig. 14 is a block diagram showing an outline of a structure of a signal identification device of the present invention. The signal identification device shown in Fig. 14 is constituted by three portions if roughly divided. The first is a sound signal decoding section 111, the second is a FACCH signal decoding section 112 and the third is a signal identification section 113. The subsequent processes will be described referring, in parallel, to a flowchart shown in Fig. 10 and the block diagram shown in Fig. 11.

The sound signal or the FACCH signal is inputted to the foregoing signal identification device. It is assumed that each of these signals is encoded. Further, it is assumed that, when these signals are encoded, encoding rates, constraint lengths, generating functions and the like differ between the signals. On the other hand, all of these conditions are not necessarily different. These conditions are basically determined based on a standard of the sound signal or the FACCH signal, and more specifically, based on an encoding procedure. Further, in view of also an aim of the present invention, it is sufficient that the conditions are different to such a degree that causes a difference in the number of generated errors when the same signal is inputted. Accordingly, it is acceptable that a part of the conditions is the same at the sound signal decoding section 111 and the FACCH signal decoding section 112 as long as a difference is caused in the number of errors relative to the same signal.

This signal is simultaneously inputted to ACS operation sections provided in the sound signal decoding section 111 and the FACCH signal decoding section 112, respectively. Here, according to the foregoing method, selection of a survivor path is performed. According to this selection, the selected path is stored in the path memory 203. Substantially simultaneously with this, a value of a path metric is stored in the metric memory 202. The decoding of the signal is performed based on the record of the path memory. On the other hand, based on the record of the metric memory 202, calculation of the number of errors is executed using the foregoing method. Specifically, each of the sound signal decoding section 111 and the FACCH signal decoding section 112 independently determines a survivor path and derives a Hamming distance between the survivor path and the received signal to determine a path metric, using the foregoing method. The thus obtained two kinds of the path metrics are outputted as the numbers of errors, respectively, along with decoded signals also determined independently. As a result of this, the numbers of errors differ between the sound signal decoding section 111 and the FACCH signal decoding section 112 even relative to the same signal input. This is based on a reason that the sound signal and the FACCH signal should be decoded based on the procedures which differ in conditions, such as the encoding rates, the constraint lengths and the generating functions. Thereafter, the decoding process is performed depending on the selected survivor paths. Further, the number of errors is derived according to the values of the path metrics. Hereinbelow, detail of the process will be described referring to the flowchart shown in Fig. 10.

First, at step 1001, the numbers of errors, correct/wrong signals and decoded signals are inputted per two kinds #1 and #2, respectively. These signals were applied with the decoding processes by the different decoding sections, respectively. Here, the number of errors is a value derived according to the value of the path metric, the correct/wrong signal is a signal representing whether or not the result of error detection in Fig. 10 is correct, and the decoded signal is a signal obtained by applying the Viterbi decoding process to the received signal inputted to the ACS operation section. Here, for facilitating understanding of the explanation, #1 corresponds to the sound signal decoding section and #2 corresponds to the FACCH signal decoding section:

Subsequently, at step 1002, it is checked whether the correct/wrong signal #1 is positive. This is a process for determining whether or not the accurate decoding was performed at the sound signal decoding section. As this signal, an error detecting code specified by TIA may be used. As a result, if the correct/wrong signal is positive, it is judged that the decoding was performed accurately. In this case, it is considered that the inputted signal is probably the sound signal. Next, at step 1003, it is checked whether the number of errors #1 exceeds a set threshold value #1a. If the number of errors #1 is no more than the set threshold value #1a, it is considered that the inputted signal may be judged to be the sound signal. At step 1004, the identification signal is set to #1, and the decoded signal #1 and the number of errors #1 are adopted as the decoded signal and the number of errors, respectively.

On the other hand, if the correct/wrong signal #1 is wrong at step 1002 or if the number of errors #1 exceeds the set threshold value #1a at step 1003, it results in that the decoding of the input signal was not performed accurately at the sound signal decoding section. As a cause of this, it is considered that the inputted signal was the FACCH signal. If the inputted signal is the FACCH signal, the inputted signal should be decoded accurately at the FACCH signal decoding section.

Accordingly, when the correct/wrong signal is wrong, step 1005 checks whether the number of errors #1 exceeds a set threshold value #1b. The set threshold value #1b may be set to be greater or smaller as compared with the set threshold value #1a. As a result of this, if the number of errors #1 is less than the set threshold value #1b. the identification signal is set to #1, and the decoded signal #1 and the number of errors #1 are adopted as the decoded signal and the number of errors, respectively, at step similar to the case where the correct/wrong signal #1 is positive. On the other hand, if the number of errors #1 is no less than the set threshold value #1b, step 1006 checks whether or not the correct/wrong signal #2 is positive. Further, when the number of errors #1 exceeds the set threshold value #1a at step 1003, step 1006 also checks whether or not the correct/wrong signal #2 is positive. As a result, if the correct/wrong signal #2 is positive, it is considered that the inputted signal is probably the FACCH signal. Next, at step 1010, it is checked whether the number of errors #2 exceeds a set threshold value #2a. If the number of errors #1 is no more than the set threshold value #2a, it is considered that the inputted signal may be judged to be the FACCH signal. At step 1009, the identification signal is set to #2, and the decoded signal #2 and the number of errors #2 are adopted as the decoded signal and the number of errors, respectively.

On the other hand, if the correct/wrong signal #2 is wrong at step 1006, step 1007 checks whether or not the number of errors #2 is no less than a set threshold value #2b. As a result, if the number of errors #2 is less than the set threshold value #2b, the identification signal is set to #2, and the decoded signal #2 and the number of errors #2 are adopted as the decoded signal and the number of errors, respectively, at step 1009 similar to the case where the correct/wrong signal #2 is positive.

On the other hand, if the number of errors #2 exceeds the set threshold value #2a at step 1010 or if the number of errors #2 is no less than the set threshold value #2b at step 1007, it is possible that the input signal was not decoded accurately also at the FACCH signal decoding section.

In this case, the number of errors #1 and the number of errors #2 are compared in magnitude at step 1008. Depending on the result, the identification signal, the decoded signal and the number of errors at a side with less number of errors are adopted at step 1004 or 1009. Thereafter, the process results are outputted.

It will be appreciated that many modifications can be made to the embodiment described above.

The present invention is suitable for various kinds of communication devices which transmit digital signals via radio or wire transmission lines, and particularly, for a communication device which performs transmission by encoding a signal to be transmitted or decoding before and after the transmission.

**Claims**

1. A method of detecting errors in a convolutionally encoded signal (101) using Viterbi decoding, the method comprising:

   establishing, using a decoding procedure, a survivor path corresponding to a decoded signal (103),
   deriving a path metric for the survivor path (104),
   determining the number of errors in the decoded signal in dependence on the value of the path metric, **characterised in that**
   the determining of the number of errors in the decoded signal comprises:

   determining whether the value of path metric exceeds a predetermined value (105) and
   setting the number of errors equal to the value of path metric if the value of path metric is the same or falls below the predetermined value (106) or
   setting the number of errors equal to a given value if the value of path metric exceeds the predetermined value,

   and the method further comprises
   outputting the number of errors together with the decoded signal and an error correction flag to indicate whether the path metric represents the number of errors (107).

2. A method according to claim 1 wherein the deriving of the value of path metric comprises determining the Hamming distance.

3. A method according to either claim 1 or 2 wherein the setting of the number of errors to a given value comprises ascribing a mean error number.

4. A method according to any preceding claim wherein establishing a survivor path comprises selecting the path with the minimum value of path metric when the path has not converged.

5. A method of distinguishing between a first and second type of encoding procedure used to encode a signal, the method comprising detecting errors in the encoded signal according to any preceding method using a first decoding procedure and determining a first number of errors and detecting errors according to any preceding method using a second decoding procedure and determining a second number of errors, comparing the first and second number of errors and in dependence on the comparison selecting either the first or second decoding procedure.

6. A method according to claim 5 wherein the selecting of either the first or second decoding procedure comprises adopting the first decoding procedure if the first number of errors is less than a first fixed value.

7. A method according to any one of claims 5 or 6 wherein the selecting of either the first or second decoding procedure comprises adopting the first decoding procedure if the first number of errors is less than the second number of errors.

8. A method according to claim 5 wherein the selecting of either the first or second decoding procedure comprises adopting the second decoding procedure if the second number of errors is less than a second fixed value.

9. A device for detecting errors in a convolutionally encoded signal comprising:

decoding means (201, 205) to establish a survivor path (702, 704), to derive a path metric for the survivor path (701, 705) and to decode the convolutionally encoded signal (706),
path memory means for storing path information (203) and
metric memory means for storing values of path metric (202) the device **characterised by** means for determining the number of errors in the decoded signal in dependence on the value of the path metric, wherein the means for determining the number of errors ascertains whether the value of path metric exceeds a predetermined value and sets the number of errors equal to the value of path metric if the value of path metric is the same or falls below the predetermined value or sets the number of errors equal to a given value if the value of path metric exceeds the predetermined value and an error operation means to output the number of errors together with the decoded signal and an error correction flag to indicate whether the path metric represents the number of errors (204).

10. A device according to claim 9 wherein the value of path metric is derived from the Hamming distance.

11. A device according to either claim 9 or 10 wherein the given value is a mean error number.

12. A device according to any one of claims 9 to 11 wherein the decoding means comprises means to select the path with the minimum value of path metric when the path has not converged.

13. Apparatus to identify and decode an encoded signal, the apparatus comprising:

a first said device for detecting errors in the encoded signal according to any one of claims 9 to 12 wherein a first said decoding means is configured to decode according to a first decoding procedure and a first said error operation means outputs a first said number of errors together with a first said decoded signal, a second said device for detecting errors in the encoded signal according to any one of claims 9 to 12 wherein a second said decoding means is configured to decode according to a second decoding procedure and a said second error operation means outputs a second said number of errors together with a second said decoded signal,
means for comparing the first and second number of errors and
means for selecting either the first or second decoded signal in dependence on the comparison.

14. Apparatus according to claim 13 wherein the means for selecting either the first or second decoded signal is configured to select the first decoded signal if the first number of errors is less than a first fixed value.

15. Apparatus according to either claim 13 or 14 wherein the means for selecting either the first or second decoded signal is configured to select the first decoded signal if the first number of errors is less than the second number of errors.

16. Apparatus according to claim 13 wherein the means for selecting either the first or second decoded signal is configured to select the second decoded signal if the second number of errors is less than a second fixed value.

**Patentansprüche**

1. Verfahren zum Erfassen von Fehlern in einem durch Faltung codierten Signal (100) unter Verwendung der Viterbi-Decodierung, wobei das Verfahren enthält:

Erstellen eines einem decodierten Signal (103) entsprechenden Überlebenspfades unter Verwendung einer Decodierungsprozedur,
Ableiten einer Pfadmetrik für den Überlebenspfad (104),
Bestimmen der Anzahl von Fehlern in dem decodierten Signal in Abhängigkeit vom Wert der Pfadmetrik, **dadurch gekennzeichnet, daß**
die Bestimmung der Anzahl von Fehlern in dem decodierten Signal umfaßt:
Bestimmen, ob der Wert der Pfadmetrik einen vorgegebenen Wert (105) übersteigt, und
Setzen der Anzahl von Fehlern gleich dem Wert der Pfadmetrik, falls der Wert der Pfadmetrik gleich oder kleiner als der vorgegebene Wert (106) ist, oder
Setzen der Anzahl von Fehlern gleich einem gegebenen Wert, falls der Wert der Pfadmetrik den vorgegebenen Wert übersteigt,
und das Verfahren ferner enthält:
Ausgeben der Anzahl von Fehlern zusammen mit dem decodierten Signal und eines Fehlerkorrekturmerkers, der angibt, ob die Pfadmetrik die Anzahl von Fehlern darstellt (107).

2. Verfahren nach Anspruch 1, bei dem das Ableiten des Wertes der Pfadmetrik das Bestimmen der Hammingdistanz umfaßt.

3. Verfahren nach einem der Ansprüche 1 oder 2, bei dem das Setzen der Anzahl von Fehlern auf einen gegebenen Wert die Zuschreibung einer mittleren Fehleranzahl umfaßt.

4. Verfahren nach irgendeinem vorangehenden Anspruch, wobei das Erstellen eines Überlebenspfades das Wählen des Pfades mit dem minimalen Wert der Pfadmetrik umfaßt, wenn der Pfad nicht konvergiert.

5. Verfahren zum Unterscheiden zwischen einem ersten Typ und einem zweiten Typ einer Codierungsprozedur, die zum Codieren eines Signals verwendet wird, wobei das Verfahren das Erfassen von Fehlern in dem codierten Signal nach irgendeinem vorangehenden Verfahren unter Verwendung einer ersten Decodierungsprozedur und das Bestimmen einer ersten Anzahl von Fehlern sowie das Erfassen von Fehlern nach irgendeinem vorangehenden Verfahren unter Verwendung einer zweiten Decodierungsprozedur und das Bestimmen einer zweiten Anzahl von Fehlern, das Vergleichen der ersten Fehleranzahl mit der zweiten Fehleranzahl und das Wählen entweder der ersten oder der zweiten Decodierungsprozedur in Abhängigkeit von dem Vergleich umfaßt.

6. Verfahren nach Anspruch 5, bei dem das Wählen entweder der ersten oder der zweiten Decodierungsprozedur die Verwendung der ersten Decodierungsprozedur umfaßt, falls die erste Anzahl von Fehlern kleiner als ein erster fester Wert ist.

7. Verfahren nach Anspruch 5 oder 6, bei dem das Wählen entweder der ersten oder der zweiten Decodierungsprozedur die Verwendung der ersten Decodierungsprozedur umfaßt, falls die erste Anzahl von Fehlern kleiner als die zweite Anzahl von Fehlern ist.

8. Verfahren nach Anspruch 5, bei dem das Wählen entweder der ersten oder der zweiten Decodierungsprozedur die Verwendung der zweiten Decodierungsprozedur umfaßt, falls die zweite Anzahl von Fehlern kleiner als ein zweiter fester Wert ist.

9. Vorrichtung zum Erfassen von Fehlern in einem durch Faltung codierten Signal, mit:

einer Decodierungseinrichtung (201, 205) zum Erstellen eines Überlebenspfades (702, 704), zum Ableiten einer Pfadmetrik für den Überlebenspfad (701, 705) und zum Decodieren des durch Faltung codierten Signals (706),
einer Pfadspeichereinrichtung zum Speichern von Pfadinformationen (203) und
einer Metrikspeichereinrichtung zum Speichern von Werten der Pfadmetrik (202),
wobei die Vorrichtung **gekennzeichnet** ist **durch**
eine Einrichtung zum Bestimmen der Anzahl von Fehlern in dem decodierten Signal in Abhängigkeit vom Wert der Pfadmetrik, wobei die Einrichtung zum Bestimmen der Anzahl von Fehlern feststellt, ob der Wert der Pfadmetrik einen vorgegebenen Wert übersteigt, und die Anzahl von Fehlern gleich dem Wert der Pfadmetrik setzt, wenn der Wert der Pfadmetrik gleich oder kleiner als der vorgegebene Wert ist, oder die Anzahl von Fehlern gleich einem vorgegebenen Wert setzt, falls der Wert der Pfadmetrik den vorgegebenen Wert übersteigt, und

eine Fehleroperationseinrichtung zum Ausgeben der Anzahl von Fehlern zusammen mit dem decodierten Signal und einem Fehlerkorrekturmerker, der angibt, ob die Pfadmetrik die Anzahl von Fehlern (204) darstellt.

10. Vorrichtung nach Anspruch 9, wobei der Wert der Pfadmetrik aus der Hammingdistanz abgeleitet wird.

11. Vorrichtung nach einem der Ansprüche 9 oder 10, wobei der vorgegebene Wert eine mittlere Fehleranzahl ist.

12. Vorrichtung nach irgendeinem der Ansprüche 9 bis 11, wobei die Decodierungseinrichtung eine Einrichtung enthält, die den Pfad mit dem minimalen Wert der Pfadmetrik wählt, wenn der Pfad nicht konvergiert.

13. Vorrichtung zum Identifizieren und Decodieren eines codierten Signals, wobei die Vorrichtung enthält:

eine erste Vorrichtung zum Erfassen von Fehlern in dem codierten Signal nach irgendeinem der Ansprüche 9 bis 12, wobei eine erste der Decodierungseinrichtungen so konfiguriert ist, daß sie gemäß einer ersten Decodierungsprozedur decodiert, und eine erste der Fehleroperationseinrichtungen eine erste Anzahl von Fehlern zusammen mit einem ersten der decodierten Signale ausgibt,
eine zweite Vorrichtung zum Erfassen von Fehlern in dem codierten Signal nach irgendeinem der Ansprüche 9 bis 12, wobei eine zweite der Decodierungseinrichtungen so konfiguriert ist, daß sie gemäß einer zweiten Decodierungsprozedur decodiert und eine zweite der Fehleroperationseinrichtungen eine zweite Anzahl von Fehlern zusammen mit einem zweiten der decodierten Signale ausgibt,
eine Einrichtung zum Vergleichen der ersten und der zweiten Anzahl von Fehlern und
eine Einrichtung zum Wählen entweder des ersten oder des zweiten decodierten Signals in Abhängigkeit vom Vergleich.

14. Vorrichtung nach Anspruch 13, wobei die Einrichtung zum Wählen entweder des ersten oder des zweiten decodierten Signals so konfiguriert ist, daß sie das erste decodierte Signal wählt, falls die erste Anzahl von Fehlern kleiner als ein erster fester Wert ist.

15. Vorrichtung nach irgendeinem der Ansprüche 13 oder 14, wobei die Einrichtung zum Wählen entweder des ersten oder des zweiten decodierten Signals so konfiguriert ist, daß sie das erste decodierte Signal wählt, falls die erste Anzahl von Fehlern kleiner als die zweite Anzahl von Fehlern ist.

16. Vorrichtung nach Anspruch 13, wobei die Einrichtung zum Wählen entweder des ersten oder des zweiten decodierten Signals so konfiguriert ist, daß sie das zweite decodierte Signal wählt, falls die zweite Anzahl von Fehlern kleiner als ein zweiter fester Wert ist.

## Revendications

1. Procédé de détection d'erreurs dans un signal (101) codé de façon convolutive, utilisant un décodage de Viterbi, le procédé comprenant :

l'établissement, en utilisant une procédure de décodage, d'un chemin survivant correspondant à un signal décodé (103),
l'élaboration d'une métrique de chemin pour le chemin survivant (104),
la détermination du nombre d'erreurs dans le signal décodé, sous la dépendance de la valeur de la métrique de chemin, caractérisé en ce que
la détermination du nombre d'erreurs dans le signal décodé comprend :

la détermination du fait que la valeur de la métrique de chemin dépasse ou non une valeur prédéterminée (105), et
la fixation du nombre d'erreurs à une valeur égale à la valeur de la métrique de chemin si la valeur de la métrique de chemin est la même que la valeur prédéterminée (106) ou tombe au-dessous de celle-ci, ou
la fixation du nombre d'erreurs à une valeur égale à une valeur donnée si la valeur de la métrique de chemin dépasse la valeur prédéterminée, et le procédé comprend en outre

la fourniture en sortie du nombre d'erreurs conjointement au signal décodé et à un drapeau de correction d'erreurs pour indiquer si la métrique de chemin représente le nombre d'erreurs (107).

2. Procédé selon la revendication 1, dans lequel l'élaboration de la métrique de chemin comprend la détermination de la distance de Hamming.

3. Procédé selon la revendication 1 ou 2, dans lequel la fixation du nombre d'erreurs à une valeur donnée comprend l'attribution d'un nombre d'erreurs moyen.

**4.** Procédé selon l'une quelconque des revendications précédentes, dans lequel l'établissement d'un chemin survivant comprend la sélection du chemin ayant la valeur minimale de métrique de chemin, lorsque le chemin n'a pas convergé.

**5.** Procédé pour distinguer entre un premier type et un second type de procédure de codage utilisée pour coder un signal, le procédé comprenant la détection d'erreurs dans le signal codé conformément à n'importe quel procédé précédent, en utilisant une première procédure de décodage, et la détermination d'un premier nombre d'erreurs et la détection d'erreurs conformément à n'importe quel procédé précédent en utilisant une seconde procédure de décodage et la détermination d'un second nombre d'erreurs, la comparaison des premier et second nombres d'erreurs et, sous la dépendance de la comparaison, la sélection de la première ou de la seconde procédure de décodage.

**6.** Procédé selon la revendication 5, dans lequel la sélection de la première ou de la seconde procédure de décodage comprend l'adoption de la première procédure de décodage si le premier nombre d'erreurs est inférieur à une première valeur fixée.

**7.** Procédé selon l'une quelconque des revendications 5 ou 6, dans lequel la sélection de la première ou de la seconde procédure de décodage comprend l'adoption de la première procédure de décodage si le premier nombre d'erreurs est inférieur au second nombre d'erreurs.

**8.** Procédé selon la revendication 5, dans lequel la sélection de la première ou de la seconde procédure de décodage comprend l'adoption de la seconde procédure de décodage si le second nombre d'erreurs est inférieur à une seconde valeur fixée.

**9.** Dispositif pour détecter des erreurs dans un signal codé de façon convolutive, comprenant :

des moyens de décodage (201, 205) pour établir un chemin survivant (702, 704), pour élaborer une métrique de chemin pour le chemin survivant (701, 705) et pour décoder le signal (706) codé de façon convolutive, des moyens de mémoire de chemin pour stocker l'information de chemin (203), et des moyens de mémoire de métrique pour stocker des valeurs de métrique de chemin (202) le dispositif étant caractérisé par des moyens pour déterminer le nombre d'erreurs dans le signal décodé sous la dépendance de la valeur de la métrique de chemin, dans lequel les moyens pour déterminer le nombre d'erreurs déterminent si la valeur de métrique de chemin dépasse une valeur prédéterminée et fixent le nombre d'erreurs égal à la valeur de la métrique de chemin si la valeur de la métrique de chemin est la même que la valeur prédéterminée ou tombe au-dessous de celle-ci, ou fixent le nombre d'erreurs égal à une valeur donnée si la valeur de la métrique de chemin dépasse la valeur prédéterminée, et des moyens de calcul d'erreurs pour émettre le nombre d'erreurs conjointement au signal décodé et à un drapeau de correction d'erreurs pour indiquer si la métrique de chemin représente le nombre d'erreurs (204).

**10.** Dispositif selon la revendication 9, dans lequel la valeur de métrique de chemin est élaborée à partir de la distance de Hamming.

**11.** Dispositif selon la revendication 9 ou 10, dans lequel la valeur donnée est un nombre d'erreurs moyen.

**12.** Dispositif selon l'une quelconque des revendications 9 à 11, dans lequel les moyens de décodage comprennent des moyens pour sélectionner le chemin ayant la valeur minimale de métrique de chemin, lorsque le chemin n'a pas convergé.

**13.** Appareil pour identifier et décoder un signal codé, l'appareil comprenant :

un premier dispositif précité pour détecter des erreurs dans le signal codé selon l'une quelconque des revendications 9 à 12, dans lequel un premier desdits moyens de décodage est configuré pour décoder conformément à une première procédure de décodage et un premier desdits moyens de calcul d'erreurs émet un premier nombre d'erreurs conjointement à un premier signal décodé, un second dispositif précité pour détecter des erreurs dans le signal codé selon l'une quelconque des revendications 9 à 12, dans lequel un second desdits moyens de décodage est configuré pour décoder conformément à une seconde procédure de décodage, et un second desdits moyens de calcul d'erreurs émet un second nombre d'erreurs conjointement à un second signal décodé, des moyens pour comparer les premier et second nombres d'erreurs et des moyens pour sélectionner le premier ou le second signal décodé sous la dépendance de la comparaison.

**14.** Appareil selon la revendication 13, dans lequel les moyens pour sélectionner le premier ou le second signal décodé sont configurés pour sélectionner le premier signal décodé si le premier nombre d'erreurs est inférieur à une première valeur fixée.

15. Appareil selon la revendication 13 ou 14, dans lequel les moyens pour sélectionner le premier ou le second signal décodé sont configurés pour sélectionner le premier signal décodé si le premier nombre d'erreurs est inférieur au second nombre d'erreurs.

16. Appareil selon la revendication 13, dans lequel les moyens pour sélectionner le premier ou le second signal décodé sont configurés pour sélectionner le second signal décodé si le second nombre d'erreurs est inférieur à une seconde valeur fixée.

INPUT RECEIVED SIGNAL — 101

KEEP RECEIVED SIGNAL — 102

VITERBI DECODING — 103

READ OUT PATH METRIC — 104

105 — PATH METRIC GREATER THAN SET VALUE ? — No

Yes

CORRECT THE NUMBER OF ERRORS — 106

OUTPUT ERROR CORRECTION SIGNAL, THE NUMBER OF ERRORS AND DECODED SIGNAL — 107

FIG. 1

VITERBI DECODING SECT

FIG. 2

EXOR-1

OUTPUT X₁

INPUT

( j ) ( a ) ( b )

3 1

OUTPUT X₂

EXOR-2

# FIG.3

FIG. 4

INPUT BIT
STRING   $(r_0(t) r_1(t))$

STATE $k0$
$s(k0, t-1)$      $\bigcirc$

$(a_0(m), a_1(m))$

STATE $m$
$s(m, t)$   $\bigcirc$

STATE $k1$
$s(k0, t-1)$      $\bigcirc$

$(b_0(m), b_1(m))$

$[r_0(t), r_1(t) = 0$ or $1]$
$[a_0(m), a_1(m) = 0$ or $1]$
$[b_0(m), b_1(m) = 0$ or $1]$
$[m, k_0, k_1 = 0 \sim 2^{k-1}]$
$[t = 1 \sim ($THE NUMBER OF ALL
INPUT BITS$/n)$

# FIG. 5

FIG. 6

START

CALCULATE METRICS OF
BRANCHES REACHING
SPECIFIC NODE — 701

KEEP PATH HAVING SMALL
METRIC IN METRIC
MEMORY — 702

KEEP PATH INFORMATION
OF PATH HAVING SMALL
METRIC IN PATH MEMORY — 703

PROCESS OF ALL BITS
OF RECEIVED SIGNAL FINISHED
? — 704

No

Yes

CALCULATE SMALLEST
METRIC — 705

DECIDE DECODED SIGNAL — 706

FIG. 7

①  $i=1, \; t=2, \; s2(m)=0, \; j=0$  ~ 8 0 1

$s \, 1(m) = s \, 2(m)$  ~ 8 0 2

INPUT $a' \, 1(i), \; a' \, 2(i)$  ~ 8 0 3

$x = a' 1(i) \oplus b1(m, k0) + a' 2(i) \oplus b(m, k0)$
$y = a' 1(i) \oplus b1(m, k1) + a' 2(i) \oplus b(m, k1)$  ~ 8 0 4

$s_x = s \, | \, (k0) + x$
$s_y = s \, | \, (k1) + y$  ~ 8 0 5

$\leq$    8 0 6    $>$

$s_x \leq s_y \; ?$

$s \, 2(m) = s_x$  ~ 8 0 7

$PM(m, \, t) = k \, 0$  ~ 8 0 8

$WM(m, \, iw) = PM(k0, \, iw)$  ~ 8 0 9

$iw = 0 \sim t-1$

$s \, 2(m) = s_y$  ~ 8 1 0

$PM(m, \, t) = k \, 1$  ~ 8 1 1

$WM(m, \, iw) = PM(k1, \, iw)$  ~ 8 1 2

$iw = 0 \sim t-1$

$m = 0 \sim 2^{n1-1}$

$PM(m, \, t) = WM(im, \, it)$  ~ 8 1 3

# FIG . 8

22

9 0 2

DELAYED
RECEIVED SIGNAL

9 0 4

DELAYING
SECT

COMPARATOR
SECT

OUTPUT
NUMBER OF
ERRORS

RE-ENCODED
SIGNAL

CONVOLUTIONAL
ENCODING SECT

9 0 3

9 0 1

VITERBI DECODING
SECT

RECEIVED
SIGNAL

DECODED
SIGNAL

FIG.9

INPUT NUMBER OF ERRORS #1,
CORRECT/WRONG SIGNAL #1,
DECODED SIGNAL #1, NUMBER OF
ERRORS #2, CORRECT/WRONG
SIGNAL #2, DECODED SIGNAL #2
— 1 0 0 1

1 0 0 2

CORRECT/WRONG
SIGNAL #1 > 0
?
No

Yes

1 3 0 3

NUMBER OF
ERRORS #1 > SET THRESHOLD
VALUE #1a ?
Yes

No

5

1 0 0 4

IDENTIFICATION SIGNAL = #1
DECODED SIGNAL = DECODED SIGNAL #1
NUMBER OF ERRORS = NUMBER OF ERRORS #1

1 4 0 5

OUTPUT IDENTIFICATION SIGNAL,
DECODED SIGNAL AND NUMBER OF
ERRORS

6

1 0 1 0

NUMBER OF
ERRORS #2 > SET THRESHOLD
VALUE #2a ?
Yes

7

No

8

5

1 0 0 5

NUMBER OF
ERRORS #1 < SET THRESHOLD
VALUE #1b ?
No

Yes

1 0 0 6

CORRECT/WRONG
SIGNAL #2 > 0
?
No

6

Yes

1 0 0 7

NUMBER OF
ERRORS #2 < SET THRESHOLD
VALUE #2b ?
Yes

7

No

1 0 0 8

NUMBER OF
ERRORS #1 > NUMBER OF
ERRORS #2 ?
No

Yes

8

1 0 0 9

IDENTIFICATION SIGNAL = #2
DECODED SIGNAL = DECODED SIGNAL #2
NUMBER OF ERRORS = NUMBER OF ERRORS #2

FIG.10

24

FIG. 11